# EUROPÄISCHE PATENTANMELDUNG

(11) **EP 3 598 588 A1**
(43) Veröffentlichungstag der Anmeldung: **22.01.2020**
(21) Anmeldenummer: 19186256.4
(22) Anmeldetag: 15.07.2019
(51) Int. Cl.: H01R 13/66, H01R 31/06, G01R 11/04, G01R 11/24, G01R 22/06, H01R 13/639

(54) **ZWISCHENSTECKER MIT MESSVORRICHTUNG, INSBESONDERE MID-ENERGIEZÄHLER, SOWIE MOBILES STROMMENGEN-MESSSYSTEM MIT MESSVORRICHTUNG**

(30) Priorität: 16.07.2018 DE 202018003270 U
(71) Anmelder: von der Lieck, Detlef, 52525 Heinsberg (DE)
(72) Erfinder: von der Lieck, Detlef, 52525 Heinsberg (DE)
(74) Vertreter: Schober, Mirko

(57) **Zusammenfassung**

Die vorliegende Erfindung betrifft einen Zwischenstecker (1) zur stromführenden Eingliederung zwischen einer Steckdose und wenigstens einem elektrischen Verbraucher. Der Zwischenstecker (1) umfasst ein Gehäuse (2) mit einem zur Kopplung mit der Steckdose ausgebildeten Gehäuse-Stecker (3) sowie wenigstens einer zur Kopplung mit einem Netzstecker ausgebildeten Gehäuse-Buchse (5). Das Gehäuse (2) besitzt eine Messvorrichtung, durch die eine über die Gehäuse-Buchse (5) weiterleitbare Menge an Strom erfassbar ist. Um eine wirksame Möglichkeit zur weitestgehend manipulationssicheren Erfassung der weitergeleiteten Menge an Strom zu erhalten, weist das Gehäuse (2) wenigstens eine Anbindevorrichtung (13, 14) auf, an die ein in die Gehäuse-Buchse (5) eingesteckter Netzstecker zumindest indirekt anbindbar ist. Weiterhin betrifft die Erfindung ein mobiles Strommengen-Messsystem, welches einen solchen Zwischenstecker (1) und wenigstens ein zur Anbindung eines mit dessen Gehäuse-Buchse (5) gekoppelten Netzsteckers an die Anbindevorrichtung (13, 14) ausgebildetes Anbindemittel umfasst.

## Beschreibung

Die vorliegende Erfindung betrifft einen Zwischenstecker zur stromführenden Eingliederung zwischen einer Steckdose und wenigstens einem elektrischen Verbraucher gemäß dem Oberbegriff von Anspruch 1, welcher ein Gehäuse mit einem zur Kopplung mit der Steckdose ausgebildeten Gehäuse-Stecker, insbesondere Schukostecker, sowie wenigstens eine zur Kopplung mit einem Netzstecker ausgebildete Gehäuse-Buchse, insbesondere Schukosteckdose, umfasst, wobei das Gehäuse ein Messvorrichtung besitzt, durch welche eine über die Gehäuse-Buchse weiterleitbare Menge an Strom erfassbar ist. Weiterhin betrifft die Erfindung ein mobiles Strommengen-Messsystem mit einem solchen Zwischenstecker gemäß den Merkmalen von Anspruch 30.

Üblicherweise bilden kabelgebundene Stecksysteme die Schnittstelle zwischen elektrischen Verbrauchern und einer diese versorgenden Wechselstromquelle. Bei letzterer kann es sich primär um ein lokales Stromnetz, aber auch um einen einzelnen Stromerzeuger oder Stromspeicher handeln. Im Bereich von Gebäuden sind hierzu beispielsweise zumeist fest installierte Steckdosen vorgesehen, deren jeweilige Buchse das Einstecken des Steckers eines Anschlusskabels wie etwa eines Netzsteckers erlaubt. Durch die dann stromleitende Kopplung steht der an der Buchse anliegende Strom sodann beispielsweise einem mit dem Stecker gegenüberliegenden Ende des Anschlusskabels verbundenen elektrischen Gerät zur Verfügung. In gleicher Weise kann die Verfügbarkeit des Stroms auch über eine weitere Distanz erstreckt und/oder auf mehrere Geräte aufgeteilt werden, indem als Anschlusskabel ein sogenanntes Verlängerungskabel oder das einer Mehrfachsteckdose verwendet wird. Eine solche Mehrfachsteckdose weist dann wiederum zwei oder mehr einzelne Buchsen auf, was die gleichzeitige Kopplung mehrerer Anschlusskabel beispielsweise mit einer einzelnen Steckdose ermöglichen.

Um die zum Betrieb elektrischer Verbraucher angefallene Menge an Strom gegenüber dem jeweiligen Stromversorger abrechnen zu können, weisen Gebäude in der Regel wenigstens eine zentrale Messvorrichtung in Form eines fest installierten Stromzählers auf. Da dieser nur zur Erfassung der insgesamt innerhalb eines Intervalls verbrauchten Menge an Strom dient, bedarf die Erfassung des Stromverbrauchs eines oder einer Anzahl an elektrischen Geräten wenigstens einer separaten Messvorrichtung. So besteht beispielsweise bei der Regulierung von Versicherungsfällen die Notwendigkeit, etwa zur Instandsetzung oder Reparatur eines Schadens verbrauchte Mengen an Strom gesondert zu erfassen. Hierzu hat sich der Einsatz handlicher Zwischenstecker mit integrierter Messvorrichtung etabliert, um diese bei Bedarf zwischen einer Steckdose und wenigstens einem elektrischen Verbraucher einzugliedern.

So wurde mit der Offenlegungsschrift DE 27 38 853 A1 ein mobiles Gerät in der Ausgestaltung eines solchen Zwischensteckers bekannt, welches dem Erfassen, Messen und Anzeigen des Energieverbrauchs elektrischer Verbraucher dient. Der Zwischenstecker umfasst ein Gehäuse, an dessen Vorderseite eine Buchse, insbesondere eine Schukosteckdose, gelegen ist. Die der Vorderseite abgewandte Rückseite des Gehäuses weist einen Stecker, insbesondere einen Schukostecker, auf, über den der Zwischenstecker beispielsweise an einer stromführenden Wand- oder Verteilersteckdose anordenbar ist. Die dann ebenfalls stromführende Buchse des Zwischensteckers ermöglicht den Anschluss und damit die Energieversorgung wenigstens eines kabelgebundenen elektrischen Verbrauchers. Um die auf diese Weise durch den Zwischenstecker hindurchleitbare Strommenge erfassen zu können, ist eine entsprechende Messvorrichtung innerhalb des Gehäuses vorgesehen. In Form einer elektronischen Messvorrichtung kann dieses mit einer von außen sichtbaren elektronischen Anzeige verbunden sein, welcher dann der jeweilige Wert der so erfassbaren Strommenge visuell entnehmbar ist.

Ähnliche Zwischenstecker mit Messvorrichtung gehen auch aus den Offenlegungsschriften DE 30 33 095 A1 und DE 36 19 053 A1 hervor.

Die bekannten Zwischenstecker ermöglichen in der Praxis die einfache Erfassung verbrauchter Strommengen. Gleichwohl bieten diese keinen wirksamen Schutz gegenüber der bewussten oder unbewussten Manipulation ihrer Messvorrichtung. Insbesondere im Zusammenhang mit Schadenssanierungen in oder an Gebäuden besteht allerdings ein Bedarf in der zugriffskontrollierten Stromversorgung der mitunter auch während der Abwesenheit des jeweiligen Dienstleisters in Betrieb befindlichen Geräte. So müssen etwa die bei einer Wasserschadenssanierung eingesetzten Trocknungsgeräte zumeist mehrtägig ohne Unterbrechung betrieben werden. Da es sich hierbei oftmals um Versicherungsfälle handelt, muss sichergestellt sein, dass die ebenfalls über den jeweiligen Versicherer zu regulierenden Stromkosten für eine solche Sanierung auch tatsächlich nur auf den Verbrauch der hierfür notwendigen Geräte zurückzuführen sind. Die steckbare Zwischenschaltung einer Messvorrichtung ermöglicht dabei keine gesicherte Erfassung der genutzten Strommenge, da nicht auszuschließen ist, dass beispielsweise ein mit der Messvorrichtung gekoppeltes Trocknungsgerät zwischenzeitlich durch ein privat genutztes elektrisches Gerät ersetzt oder dieses einfach zusätzlich mit der Messvorrichtung gekoppelt wird. Im Ergebnis würde die dem privaten Verbrauch zuzuordnende Strommenge dann zu Unrecht dem Versicherer in Rechnung gestellt.

Gemäß den eichrechtlichen Vorschriften gelten beispielsweise Sanierungsfirmen als sogenannte "Messgeräteverwender" bzw. "Messwerteverwender", was diese zur Beachtung des Mess- und Eichgesetzes (MessEG) verpflichtet. Diese sind für die Erfassung und Weitergabe der jeweiligen Messwerte zuständig, auf deren Basis die Kosten des durch die Geräte verbrauchten Stroms zu ermitteln sind. Unabhängig des Einsatzes interner oder externer Messvorrichtungen sehen die sich hieraus ergebenden Anforderungen vor, dass während der zu erfassenden Betriebsdauer der erforderlichen Geräte keine weiteren elektrischen Verbraucher unberechtigt angeschlossen werden können. Dies stellt im praktischen Einsatz insbesondere die Verwendung von Mehrfachsteckdosen vor entsprechende Fragen, so dass deren in Bezug auf die möglichen Manipulationen bekannten Vorrichtungen und Systeme insgesamt noch Raum für Verbesserungen lassen.

Vor diesem Hintergrund liegt der vorliegenden Erfindung die Aufgabe zugrunde, einen gattungsgemäßen Zwischenstecker dahingehend weiterzuentwickeln, dass dieser eine wirksame Möglichkeit zur weitestgehend manipulationssicheren Erfassung der über ihn weitergeleiteten Menge an Strom bietet. Weiterhin soll ein Strommengen-Messsystem aufgezeigt werden, welches einen wirksamen Manipulationsschutz insbesondere durch Anzeigen einer erfolgten Manipulation bietet.

Die Lösung dieser Aufgabe besteht nach der Erfindung in einem Zwischenstecker mit den Merkmalen von Anspruch 1. Weiterhin wird diese Aufgabe mit einem Strommengen-Messsystem gemäß den Merkmalen des Anspruchs 30 gelöst. Vorteilhafte Weiterbildungen sind Inhalt der hiervon abhängigen Ansprüche 2 bis 29 sowie 31.

Es sei an dieser Stelle zunächst darauf hingewiesen, dass die in der nachfolgenden Beschreibung einzeln aufgeführten Merkmale selbstverständlich in beliebiger sowie technisch sinnvoller Weise miteinander kombiniert werden können und damit weitere Ausgestaltungen der Erfindung aufzeigen. Weiterhin ist die Erfindung nicht auf die genannten Ausführungsbeispiele und beispielhaft erwähnten Inhalte beschränkt, so dass den Grundgedanken der Erfindung weiterführende Ausgestaltungen ebenfalls als Teil von dieser anzusehen sind.

Der Kerngedanke des erfindungsgemäßen Zwischensteckers ist darin zu sehen, dass dessen Gehäuse nunmehr eine zur Manipulationssicherung dienende Anbindevorrichtung aufweist. Unter einer solchen Anbindevorrichtung wird im Rahmen der Erfindung eine eigens hierfür vorgesehene strukturelle Ausgestaltung des Gehäuses oder die entsprechende Anordnung einer solchen an dem Gehäuse verstanden. Die Ausgestaltung und Anordnung dieser wenigstens einen Anbindevorrichtung ist dabei so gewählt, dass ein in die Gehäuse-Buchse des Zwischensteckers eingesteckter Netzstecker eines elektrischen Geräts oder einer elektrischen Maschine zumindest indirekt an diese Anbindevorrichtung anbindbar ist. Anbindbar meint dabei eine Festlegung des eingesteckten Netzsteckers an dem Zwischenstecker in der Form, dass der Netzstecker nicht oder nicht ohne Beschädigung durch eine unbefugte Person von dem Zwischenstecker trennbar ist. Bevorzugt kann besagte Anbindung durch Nutzung eines separaten Anbindemittels erfolgen, um einen Teil des Netzsteckers mit wenigstens einem Teil der Anbindevorrichtung zu verbinden.

Dem direkten Anschluss eines Geräte- oder Maschinen-Netzsteckers an den Zwischenstecker gleichgestellt sind natürlich auch solche Verbindungen, die beispielsweise unter Zwischenschaltung eines geeigneten Verlängerungskabels zustande kommen.

Der sich hieraus ergebende Vorteil liegt in der einfachen sowie kostengünstigen und überaus wirksamen Möglichkeit zur quasi unlösbaren Zuordnung eines elektrischen Geräts oder einer elektrischen Maschine in Bezug auf den die verbrauchte Strommenge erfassenden Zwischenstecker. Hierdurch ist es möglich, auch ohne eine interne Messvorrichtung ausgestattete Verbraucher insbesondere in hinsichtlich der Verbrauchserfassung sensiblen Bereichen einzusetzen. Dank der jeweils eindeutigen Verbindung des hinsichtlich seines Verbrauchs an Strom zu erfassenden Geräts oder der Maschine ist eine weitestgehend manipulationssicheren Erfassung der über den eingegliederten Zwischenstecker weitergeleiteten Menge an Strom gegeben. Zwar ist ein Eingriff auch weiterhin in der Form möglich, dass die Verbindung zwischen einem eingesteckten Netzstecker und dem Zwischenstecker gewaltsam erfolgen kann, allerdings bietet die dann offensichtlich erkennbare Manipulation nicht nur im Anschluss genügend Beweise zur Abwendung unberechtigter Forderungen, sondern bereits im Vorfeld genügend abschreckende Wirkung.

Gemäß einer besonders bevorzugten Weiterbildung des grundsätzlichen Erfindungsgedankens kann die Anbindevorrichtung wenigstens eine Durchgangsöffnung aufweisen. Die Durchgangsöffnung stellt eine einfache und intuitive Möglichkeit zur Anbindung eines Netzsteckers an die Anbindevorrichtung des Zwischensteckers dar, insbesondere im Rahmen der Verwendung eines separaten, beispielsweise strangförmigen, Anbindemittels. Dieses kann beispielsweise in geeigneter Weise um den jeweiligen Netzstecker oder dessen zugehöriges Kabel gelegt und/oder gewickelt sowie durch die Durchgangsöffnung hindurchgeführt werden. Im Sinne einer Plombe dient das Anbindemittel dann als mechanisches Verbindungsmittel und als Indikator einer möglicherweise erfolgten Manipulation durch dessen Beschädigung oder gar Zerstörung.

In vorteilhafter Weise kann die Anbindevorrichtung wenigstens einen Bügel besitzen. Bevorzugt kann die Durchgangsöffnung der Anbindevorrichtung dabei zumindest teilweise durch den Bügel begrenzt sein. Bügelformen stellen naturgemäß eine einfache und hinsichtlich ihrer Gestalt zumeist ästhetische Form für die angedachte Anbindung dar. Gegenüber einer sich mitten in einem Teilbereich befindenden Durchgangsöffnung bietet der Bügel eine bessere Handhabung, da die von ihm zumindest bereichsweise begrenzte Durchgangsöffnung insofern randnah gelegen und damit gut zu erreichen ist.

Hinsichtlich der Anordnung des Bügels in Bezug auf die Anbindevorrichtung kann dieser zumindest abschnittsweise gekrümmt ausgebildet sein. Sofern besagte Krümmung oder Biegung beispielsweise parallel zur üblicherweise rund ausgestalteten Gehäuse-Buchse verläuft, erleichtert der insofern gleichbleibende Abstand jedes Abschnitts des so gestalteten Bügels die Anbindung eines Netzsteckers. Auch kann beispielsweise ein Anbindemittel eine notwendigen Bewegung des über dieses an die Anbindevorrichtung angebundenen Netzsteckers entlang des gekrümmten Bügels spannungsfrei folgen. Überdies passt sich eine gekrümmte Bügelform harmonischer und insbesondere ohne mitunter störende Kanten und Ecken in die Gestaltung des Gehäuses ein.

Gemäß einer vorteilhaften Weiterentwicklung des erfindungsgemäßen Zwischensteckers kann dessen Gehäuse wenigstens eine Nut aufweisen. In besonders bevorzugter Weise kann die Anbindevorrichtung zumindest teilweise im Bereich dieser Nut angeordnet sein. Aufgrund der gegenüber der Oberfläche des Gehäuses zurückspringenden Natur ihres Nutgrunds schafft die Nut einen offenen Raum, um die Anbindevorrichtung zumindest teilweise aufzunehmen. Hierdurch können die Abmessungen des Gehäuses im Vergleich zu den Gehäusen bisher bekannter Zwischenstecker trotz der zusätzlichen Anordnung wenigstens einer Anbindevorrichtung weitestgehend beibehalten bleiben, indem der in der Regel nicht vollständig genutzte Innenraum eines solchen Gehäuses für die Anordnung wenigstens einer, die Anbindevorrichtung zumindest teilweise aufnehmenden Nut genutzt wird.

Hinsichtlich der Anordnung der wenigstens einen Nut wird es im Rahmen der Erfindung als vorteilhaft angesehen, wenn diese an wenigstens einer der beiden sich gegenüberliegenden Gehäuseseiten des Gehäuses angeordnet ist. Besonders bevorzugt kann an jeder der beiden Gehäuseseiten des Gehäuses jeweils eine solche Nut angeordnet sein, die dann beispielsweise den Gehäuse-Stecker und/oder die Gehäuse-Buchse zwischen sich einschließen können. Auf diese Weise ist die Nut oder sind die Nuten und insofern auch die wenigstens eine Anbindevorrichtung unmittelbar im Bereich um die Gehäuse-Buchse herum gelegen, was eine besonders benutzerfreundliche Anbindung eines in diese eingesteckten Netzsteckers ermöglicht. Überdies fügt sich die Lage der Nut/en so in gestalterisch vorteilhafter Weise in die Form des Gehäuses ein. In besonders bevorzugter Weise wird die wenigstens eine Nut durch den Bügel der Anbindevorrichtung überbrückt, so dass der zwischen Nutgrund und den zugehörigen Flanken der Nut sowie dem Bügel verbleibende offene Querschnitt die Durchgangsöffnung bilden kann.

Mit Blick auf das Gehäuse kann dieses bevorzugt wenigstens zweigeteilt sein. Dies erleichtert dessen Herstellung sowie Bestückung mit den erforderlichen Bauteilen des erfindungsgemäßen Zwischensteckers. Zu diesen zählen beispielsweise notwendige Verbindungen zwischen den stromführenden Teilen zwischen Gehäuse-Stecker und Gehäuse-Buchse sowie die in der Regel zwischen diesen integrierte Messvorrichtung. Hiernach kann das Gehäuse einen den Gehäuse-Stecker aufweisenden Gehäuse-Kasten und einen die Gehäuse-Buchse aufweisenden Gehäuse-Deckel umfassen. Hinsichtlich der Tiefe beziehungsweise Dicke der jeweiligen Teile des Gehäuses kann der Gehäuse-Kasten gegenüber dem Gehäuse-Deckel entsprechend größer gestaltet sein, um beispielsweise die zuvor angesprochenen notwendigen Bauteile aufnehmen zu können. Besonders bevorzugt kann die wenigstens eine Anbindevorrichtung am Gehäuse-Deckel im Bereich der Gehäuse-Buchse angeordnet sein. Damit ist sichergestellt, dass die wenigstens eine Anbindevorrichtung im Bereich der Vorderseite des Zwischensteckers gelegen und damit stets gut zu erreichen ist.

Gemäß einer bevorzugten Weiterbildung des zweiteiligen Aufbaus des Gehäuses sieht die Erfindung vor, dass sich die wenigstens eine Nut von einer Rückseite des Gehäuses, insbesondere des Gehäuse-Kastens, aus bis hin zum Gehäuse-Deckel erstrecken kann. Mit anderen Worten ist besagte Nut damit zu seinen beiden gegenüberliegenden Enden hin offen ausgestaltet. In vorteilhafter Weise kann sich die Nut dann bis in die Seiten des Gehäuse-Deckel hinein erstrecken. Um einen möglichst quasi nahtlosen Übergang zu ermöglichen, ist ferner vorgesehen, dass sich der Nutgrund der Nut sowie eine dem Bügel der Anbindevorrichtung gegenüberliegende und die Durchgangsöffnung zumindest bereichsweise begrenzende Teilfläche des Gehäuse-Deckels auf einer gemeinsamen Ebene erstrecken können. Auf diese Weise verläuft der Nutgrund ohne Höhensprung bis unterm dem Bügel hindurch, was ein überaus vorteilhaftes da ohne unnötige Störkanten auskommendes Einfädeln eines Anbindemittels in und durch die Durchgangsöffnung der Anbindevorrichtung hindurch ermöglicht.

Aufgrund des Vorgenannten wird es im Rahmen der Erfindung als vorteilhaft angesehen, wenn auch der Verlauf der unterhalb des Bügels gelegenen und eine Verlängerung des Nutgrunds darstellende Teilfläche wie dieser ausgestaltet ist. So können Nutgrund und besagte Teilfläche bevorzugt identisch gekrümmt ausgebildet sein. Unabhängig davon wir eine Krümmung des Nutgrunds und/oder der Teilfläche als vorteilhaft angesehen, da dies insbesondere im Zusammenhang mit einem in gleiche Richtung gekrümmten Bügel einen nahezu gleichbleibenden Öffnungsquerschnitt der Durchgangsöffnung ermöglicht.

Um einen möglichst nahtlosen Übergang zwischen der wenigstens einen Nut und deren verlängertem Verlauf im Gehäuse-Deckel zu erhalten wird weiterhin vorgeschlagen, dass eine im Bereich des Gehäuse-Deckels gelegene Breite des Nutgrunds einer im Bereich des Gehäuse-Kastens gelegene Breite der Teilfläche entsprechen kann.

Insgesamt sieht die Erfindung vor, dass die Querschnittsform der wenigstens einen Nut zumindest bereichsweise der Querschnittsform der Durchgangsöffnung der Anbindevorrichtung entsprechen kann. Weiterhin kann der Verlauf der Nut sich zumindest bereichsweise im Verlauf der Durchgangsöffnung fortsetzen. Auch können eine die Nut begrenzende Nutflanke und eine die Durchgangsöffnung zumindest bereichsweise begrenzende Öffnungsflanke sich auf einer gemeinsamen Ebene erstrecken. Besonders bevorzugt kann dies für beide sich gegenüberliegende Nutflanken und die zugehörigen Öffnungsflanken gelten. Mit der so erreichbaren zunehmenden Anpassung zwischen Durchgangsöffnung und Nut erleichtert sich insbesondere das Einfädeln eines Anbindemittels.

Das Gehäuse des erfindungsgemäßen Zwischensteckers kann einen unteren Wandabschnitt und einen dem unteren Wandabschnitt gegenüberliegenden oberen Wandabschnitt besitzen, wobei wenigstens ein an einer der beiden Gehäuseseiten gelegener seitlicher Wandabschnitt sich dann zwischen dem unteren Wandabschnitt und der an dieser Gehäuseseite angeordneten Nut erstreckt. In dieser Ausgestaltung können der untere Wandabschnitt und der wenigstens eine seitliche Wandabschnitt über eine Schrägfläche miteinander verbunden sein. Besagte Schrägfläche nimmt dem Gehäuse wenigstens eine ansonsten mitunter störende Kante im Sinne eines rechten Winkels, was neben einer gefälligeren Optik insbesondere die Haptik im direkten Kontakt mit dem Zwischenstecker verbessert. So können die Schrägfläche und der untere Wandabschnitt und/oder der seitliche Wandabschnitt, insbesondere jeweils, einen Winkel von 115° bis 155° zwischen sich einschließen. Alternativ kann der so eingeschlossene Winkel auch von 125° bis 145° betragen. Bevorzugt kann der Winkel einen Wert von 135° aufweisen, so dass der untere Wandabschnitt und der zugehörige seitliche Wandabschnitt jeweils einen Winkel mit demselben Wert (135°) zwischen sich und der Schrägfläche einschließen.

Eine überaus kompakte und optisch ansprechende Form des Gehäuses kann erreicht werden, indem der obere Wandabschnitt konvex gekrümmt ist. Insbesondere bei einer nach außen hin konvexen Form des oberen Wandabschnitts kann diese sich dabei parallel zur in der Regel rund ausgestalteten Gehäuse-Buchse erstrecken. Zusammen mit der gekrümmten Form des Bügels der wenigstens einen Anbindevorrichtung können deren jeweiligen Biegungen sich so bevorzugt zu einer harmonischen Gesamtkrümmung ergänzen. Insbesondere in der bevorzugten Ausgestaltung, bei der die beiden Gehäuseseiten jeweils eine Nut aufweisen, kann der gekrümmte obere Wandabschnitt sich dann zwischen den beiden Nuten, insbesondere zwischen deren jeweiligen im Übergangsbereich zwischen einer ihrer Flanken und der zugehörigen Gehäuseseite gelegenen Kanten, erstrecken.

Bezüglich einer möglichst kompakten und im Handling vorteilhaften Ausgestaltung des Gehäuses sieht die Erfindung vor, dass dieses sich von seiner Vorderseite ausgehend zu seiner Rückseite hin verjüngen kann. Diese Form erleichtert das Abziehen des über seinen Gehäuse-Stecker beispielsweise mit einer Steckdose gekoppelten Zwischensteckers, da insbesondere die somit schräg verlaufenden und beim Abziehen zumindest teilweise umgriffenen Gehäuseseiten einen verbesserten Kontakt zu einer menschlichen Hand aufweisen. Letztlich ist das Gehäuse hierdurch zu seiner Vorderseite entsprechend verdickt. Selbstverständlich kann sich besagte Verjüngung auch nur auf den Gehäuse-Kasten beschränken, der sich hierdurch zum Gehäuse-Deckel hin entsprechend verdickt.

Um beispielsweise das Eindringen von Fremdkörpern in die Gehäuse-Buchse zu verhindern, kann diese zumindest bereichsweise durch eine Abdeckung verdeckt sein. Auch wenn die Abdeckung beispielsweise als separates Bauteil vollständig vom Gehäuse lösbar ausgestaltet sein kann, wird es als vorteilhaft angesehen, wenn diese unverlierbar am Gehäuse befestigt ist. Um den notwendigen Zugang zu den stromführenden Teilen der Gehäuse-Buchse zu ermöglichen, kann die Abdeckung daher an dem Gehäuse, insbesondere an dessen Gehäuse-Deckel, schwenkbar angeordnet sein. Denkbar ist auch eine verschließbare Ausbildung der Abdeckung.

Damit die Abdeckung eine im ungenutzten Zustand des Zwischensteckers stets die Gehäuse-Buchse verdeckende Stellung einnimmt und beibehält wird vorgeschlagen, dass diese entsprechend federbelastet sein kann. Für einen Zugang zur Gehäuse-Buchse muss die Abdeckung dann entgegen einer diese im die Gehäuse-Buchse verdeckenden Zustand haltenden Federkraft verschwenkt werden, was im Umkehrschluss ein selbsttätiges Verdecken der Gehäuse-Buchse durch Zurückschwenken der Abdeckung bewirkt.

Angesichts der bereits zum Ende 2006 in Kraft getretenen Europäischen Messgeräterichtlinie MID (Measuring Instruments Directive) 2004/22/EG kann die Messvorrichtung in bevorzugter Weise grundsätzlich als MID-Energiezähler mit entsprechender Herstellerkonformitätsbewertung ausgebildet sein.

Das Gehäuse des erfindungsgemäßen Zwischensteckers kann wenigstens ein Anzeigemittel besitzen, welches zur zumindest bedarfsweisen Darstellung eines Werts für die jeweils erfasste Menge an Strom dient. Bei dem Anzeigemittel kann es sich beispielsweise um eine Segmentanzeige oder ein Display handeln, insbesondere LCD oder LED. Selbstverständlich kann dieses auch als Matrixdisplay ausgebildet sein oder ein solches enthalten. Das direkt an dem Gehäuse sichtbar angeordnete Anzeigemittel hat den Vorteil einer leichten Ablesbarkeit, wobei insbesondere bei der gleichzeitigen Nutzung mehrerer erfindungsgemäßer Zwischenstecker eine eindeutige Zuordnung des so erfassten Verbrauchs in Bezug auf die jeweils angeschlossenen Geräten und/oder Maschinen gegeben ist. Eine bedarfsweise Darstellung meint hierbei, dass das Anzeigemittel in Bezug auf seine Anzeige und/oder Hintergrundbeleuchtung beispielsweise aus Gründen der Energieeinsparung nicht dauerhaft aktiv sein muss. So kann dieses beispielsweise nur bei Bedarf hinsichtlich seiner anzeigenden Eigenschaft aktivierbar ausgebildet sein. Aus diesem Grund kann der erfindungsgemäße Zwischenstecker ein Bedienelement aufweisen, so dass beispielsweise das Anzeigen des oder der erfassten Werte nur bei dessen Betätigung erfolgt. Die Anzeige kann dabei nur für die Dauer seiner Betätigung erfolgen oder für die Dauer einer bei Betätigung beginnenden Zeitspanne. Auch kann das Bedienelement im Sinne eines Kippschalters aufgebaut sein, was ein aktives An- sowie Ausschalten des Anzeigemittels über das Bedienelement meint.

Idealerweise kann das Anzeigemittel an einer Vorderseite des Gehäuses, insbesondere an dessen Gehäuse-Deckel, angeordnet sein. Eine derartige Anordnung erleichtert dessen Ablesbarkeit, da dieses stets zumindest teilweise sichtbar an der im Wahrnehmungsbereich liegenden Front des Zwischensteckers gelegen ist.

Hinsichtlich einer möglichst vorteilhaften Kraftweiterleitung insbesondere beim Einstecken eines Netzsteckers in die Gehäuse-Buchse kann diese zusammen mit dem ihr gegenüberliegenden Gehäuse-Stecker fluchtend in und/oder an dem Gehäuse angeordnet sein. Hierdurch wird die zum Einstecken eines Netzsteckers erforderliche Kraft direkt über den dahinterliegenden Gehäuse-Stecker in die jeweilige Steckdose geleitet, ohne ein mitunter nachteiliges Verkanten des Zwischensteckers.

Der Aufbau des Gehäuses kann grundsätzlich aus mehreren Einzelteilen erfolgen oder insgesamt materialeinheitlich einstückig ausgeführt sein. Besonders bevorzugt wird eine zweiteilige Ausführung des Gehäuses, bei welcher der untere und obere Wandabschnitt sowie die beiden seitlichen Wandabschnitte zusammen mit der wenigstens einen Nut und der Rückseite des Gehäuses materialeinheitlich einstückig ausgebildet sein können. In dieser Ausgestaltung können die genannten Bereiche allesamt den Gehäuse-Kasten bilden oder Teil von diesem sein. Weiterhin kann auch ein Grundkörper der Gehäuse-Buchse materialeinheitlich einstückig mit den vorgenannten Bereichen ausgebildet sein.

Der nunmehr vorgestellte erfindungsgemäße Zwischenstecker bietet eine überaus wirksame Möglichkeit zur weitestgehend manipulationssicheren Erfassung der jeweiligen, über ihn an wenigstens einen Verbraucher weitergeleiteten Menge an Strom. Insbesondere die Anordnung und/oder Integration wenigstens einer Anbindevorrichtung in oder an seinem Gehäuse gestattet eine einfache und intuitive Anbindung eines in die Gehäuse-Buchse eingesteckten Netzsteckers an den Zwischenstecker, so dass dieser nur durch Unbefugte abgezogen werden kann. Je nach Ausgestaltung eines zur Anbindung dienenden zusätzlichen Anbindemittels kann eine mögliche Manipulation durch dessen Beschädigung oder gar Zerstörung angezeigt werden.

Die Erfindung ist weiterhin auch auf ein mobiles Strommengen-Messsystem gerichtet, welches wenigstens einen, insbesondere mobilen, Zwischenstecker sowie wenigstens ein Anbindemittel umfasst. Bei besagtem Zwischenstecker handelt es sich um den zuvor aufgezeigten erfindungsgemäßen Zwischenstecker. Das Anbindemittel ist dazu ausgebildet, einen mit der Gehäuse-Buchse des Zwischensteckers gekoppelten Netzstecker an die wenigstens eine Anbindevorrichtung des Zwischensteckers, insbesondere ausziehsicher, anzubinden. Die sich hieraus ergebenden Vorteile wurden bereits zuvor im Zusammenhang mit dem erfindungsgemäßen Zwischenstecker näher erläutert, so dass zur Vermeidung von Wiederholungen an dieser Stelle auf die entsprechenden Ausführungen hierzu verwiesen wird.

Gemäß einer besonders bevorzugten Weiterbildung des erfindungsgemäßen Strommengen-Messsystems kann das Anbindemittel in vorteilhafter Weise strangförmig ausgebildet sein, was eine besonders einfache Handhabung hinsichtlich der Anbindung eines Netzsteckers an die Anbindevorrichtung ermöglicht. Insbesondere dessen dann mögliche flexible Ausgestaltung erleichtert beispielsweise das zumindest teilweise umwickeln des Netzsteckers und/oder dessen Anschlusskabel, was dann auch für das Hindurchführen durch die Durchgangsöffnung der Anbindevorrichtung gilt. Selbstverständlich kann das Anbindemittel beispielsweise auch als Bügelschloss ausgebildet sein oder ein solches enthalten. Denkbar wäre auch eine Kombination aus einem Strangförmigen Element und einer verrastenden, bevorzugt abschließbaren, Einrichtung, die dann beispielsweise dem Verbinden zweier loser Enden eines solchen strangförmigen Elements dient. Über ein Zylinder- oder Zahlenschloss ist das Öffnen des strangförmigen Elements dann nur einer befugten Person möglich.

In vorteilhafter Weise kann das Anbindemittel gemäß wenigstens einer der nachfolgend genannten Ausführungsformen ausgebildet sein oder wenigstens eine dieser Ausführungsformen enthalten:
- Kabelbinder,
- Drahtplombe,
- Fadenplombe,
- Bandplombe,
- Plombierdraht,
- Plombierfaden,
- Plombierband.

Ein solches Anbindemittel kann so gefertigt sein, dass dieses ein nur einmaliges Verschließen zulässt, während das Öffnen seine Zerstörung oder zumindest Beschädigung verlangt. Auf diese Weise ist eine zwischenzeitlich erfolgte mögliche Manipulation in jedem Fall aufgrund des Zustands des Anbindemittels erkennbar.

Die Erfindung wird nachfolgend anhand eines in den Figuren schematisch dargestellten Ausführungsbeispiels näher erläutert, aus denen auch weitere vorteilhafte Einzelheiten und Wirkungen hervorgehen können. Es zeigen:
- Fig. 1: einen erfindungsgemäßen Zwischenstecker in einer perspektivischen Darstellungsweise seiner Vorderseite,
- Fig. 2: den Zwischenstecker aus Fig. 1 in einer perspektivischen Darstellungsweise seiner Rückseite,
- Fig. 3: den Zwischenstecker aus den Fig. 1 und 2 in einer Ansicht mit Blick auf dessen Vorderseite,
- Fig. 4: den Zwischenstecker aus den Fig. 1 bis 3 in einer Ansicht mit Blick auf eine erste seiner beiden Gehäuseseiten,
- Fig. 5: den Zwischenstecker aus den Fig. 1 bis 4 in einer Ansicht mit Blick auf eine zweite seiner beiden Gehäuseseiten sowie
- Fig. 6: ein den Zwischenstecker aus den Fig. 1 bis 5 umfassendes mobiles Strommengen-Messsystem in perspektivischer Darstellungsweise.

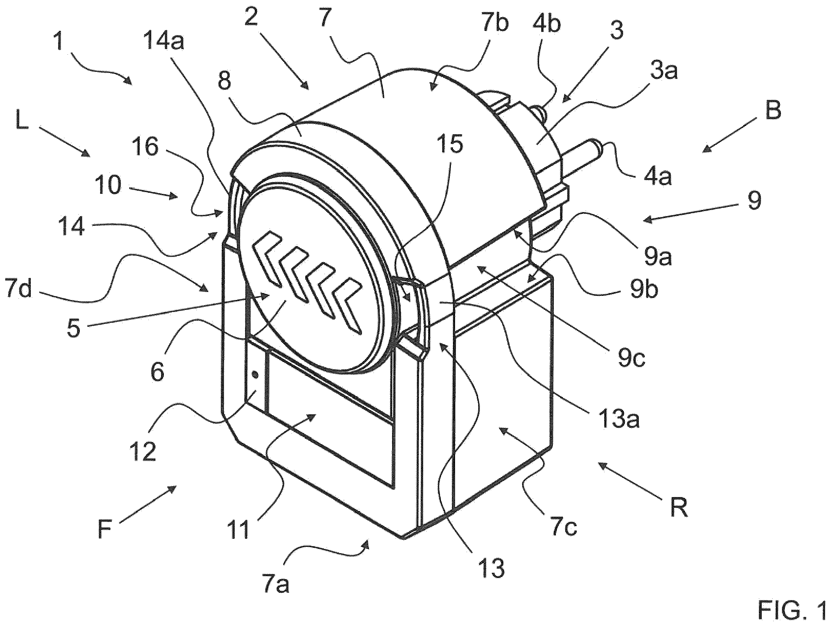

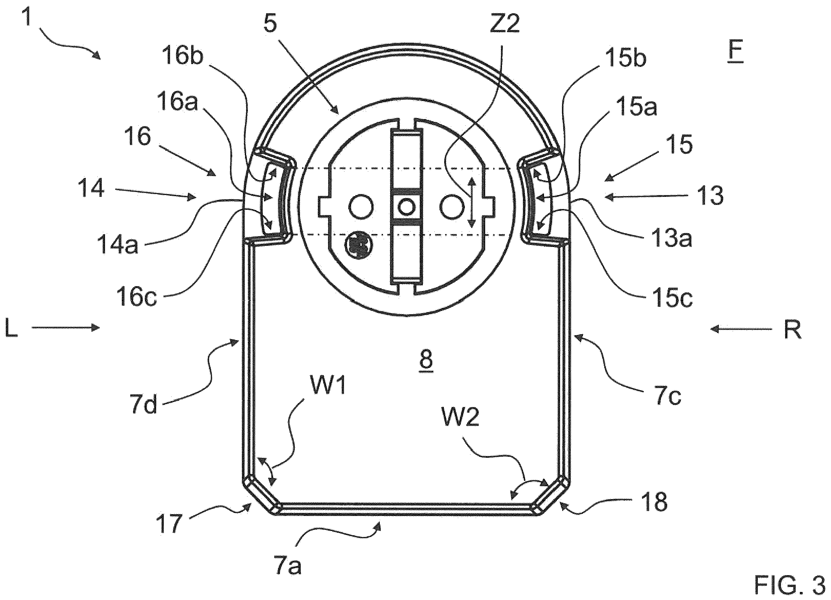

Fig. 1 zeigt einen erfindungsgemäßen Zwischenstecker 1 in einer perspektivischen Darstellung. Der Zwischenstecker 1 umfasst ein Gehäuse 2, welches an seiner Rückseite B einen zur Kopplung mit einer hier nicht näher dargestellten Steckdose ausgebildeten Gehäuse-Stecker 3 aufweist. Der Gehäuse-Stecker 3 weist einen Grundkörper 3a bekannter Bauart auf, an dessen Stirnseite zwei Kontaktstifte 4a, 4b angeordnet sind. Weiterhin weist das Gehäuse 2 eine an seiner Vorderseite F gelegene Gehäuse-Buchse 5 auf, die vorliegend über eine Abdeckung 6 vollständig verdeckt ist. Gehäuse-Stecker 3 und Gehäuse-Buchse 5 sind miteinander fluchtend an dem Gehäuse 2 angeordnet. Erkennbar ist die Abdeckung 6 kreisrund ausgebildet, so dass diese an die Grundform der insbesondere in Fig. 3 ersichtlichen Gehäuse-Buchse 5 angepasst ist. In ihrer Anordnung ist die Abdeckung 6 in nicht näher ersichtlicher Weise, beispielsweise seitlich, schwenkbar an dem Gehäuse 2 angeordnet. Die Abdeckung 6 verbleibt dabei stets in einem die Gehäuse-Buchse 5 verdeckenden Zustand, sofern diese nicht aktiv aus diesem Zustand heraus verschwenkt wird. Hierzu ist die Abdeckung 6 entsprechend federbelastet, so dass diese entgegen einer Federkraft verschwenkt werden muss, um einen Zugang zur Gehäuse-Buchse 5 zu erhalten.

Der Gehäuse-Stecker 3 ist in üblicher Weise zur stromführenden Kopplung mit einer hier nicht näher dargestellten Steckdose vorgesehen, während die Gehäuse-Buchse 5 der stromführenden Kopplung mit einem hier ebenfalls nicht näher gezeigten Netzstecker dient. In dieser Ausgestaltung ist der Zwischenstecker 1 zur stromführenden Eingliederung zwischen einer Steckdose und wenigstens einem elektrischen Verbraucher vorgesehen.

Das Gehäuse 2 ist zweiteilig aufgebaut, wobei es sich im Wesentlichen aus einem den Gehäuse-Stecker 3 aufweisenden Gehäuse-Kasten 7 und einem die Gehäuse-Buchse 5 aufweisenden Gehäuse-Deckel 8 zusammensetzt. Der Gehäuse-Kasten 7 des Gehäuses 2 umfasst einen unteren Wandabschnitt 7a und einen dem unteren Wandabschnitt 7a gegenüberliegenden oberen Wandabschnitt 7b, während an zwei sich gegenüberliegenden Gehäuseseiten L, R des Gehäuses 2 je ein seitlicher Wandabschnitt 7c, 7d gelegen ist. Das Gehäuse 2 weist an seinen beiden Gehäuseseiten L, R je eine Nut 9, 10 auf, welche jeweils in einer der beiden seitlichen Wandabschnitte 7c, 7d des Gehäuse-Kastens 7 angeordnet sind. Beide Nuten 9, 10 sind durch je zwei Flanken 9a, 9b; 10a, 10b seitlich begrenzt, zwischen denen sich jeweils ein zugehöriger Nutgrund 9c, 10c erstreckt. Vorliegend ist nur die an der in Fig. 1 ersichtlichen Gehäuseseite R am seitlichen Wandabschnitt 7c angeordnete Nut 9 erkennbar, während die am anderen seitlichen Wandabschnitt 7d der gegenüberliegenden Gehäuseseite L gelegene Nut 10 entsprechend verdeckt ist. Beide seitlichen Wandabschnitte 7c, 7d erstrecken sich jeweils zwischen dem unteren Wandabschnitt 7a und der zugehörigen Nut 9, 10. Gegenüber den jeweils eben ausgebildeten seitlichen Wandabschnitten 7c, 7d und dem ebenfalls eben ausgebildeten unteren Wandabschnitt 7a weist der obere Wandabschnitt 7b eine gekrümmte Form auf, wobei er nach außen hin konvex ausgebildet ist. Die einachsige Krümmung des oberen Wandabschnitts 7b verläuft dabei derart, dass diese sich zwischen den beiden Nuten 9, 10 erstreckt.

Der Gehäuse-Kasten 7 ist bevorzugt aus einem Kunststoff gefertigt, wobei der untere Wandabschnitt 7a und der obere Wandabschnitt 7b, die beiden seitlichen Wandabschnitte 7c, 7d zusammen mit den beiden Nuten 9, 10 sowie der Rückseite B des Gehäuses 2 und der Grundkörper 3a des Gehäuse-Steckers 3 materialeinheitlich einstückig ausgebildet sind.

An der Vorderseite F des Gehäuses 2 - näherhin an dessen Gehäusedeckel 8 - ist ein Anzeigemittel 11 einer ansonsten nicht weiter ersichtlichen Messvorrichtung angeordnet. Bei der Messvorrichtung handelt es sich bevorzugt um einen MID-Energiezähler, welcher zur Erfassung einer über die Gehäuse-Buchse 5 weitergeleiteten Menge an Strom eingerichtet ist. In dieser Anordnung ist das Anzeigemittel 11 zur zumindest bedarfsweisen Darstellung eines Werts für die jeweils erfasste Menge an Strom ausgebildet. Weiterhin ist ein Bedienelement 12 neben dem Anzeigemittel 11 angeordnet, welche der Ansteuerung - beispielsweise dem Ein- und Ausschalten oder einem Reset des erfassten Werts - des Anzeigemittels 11 und/oder der Messvorrichtung dient.

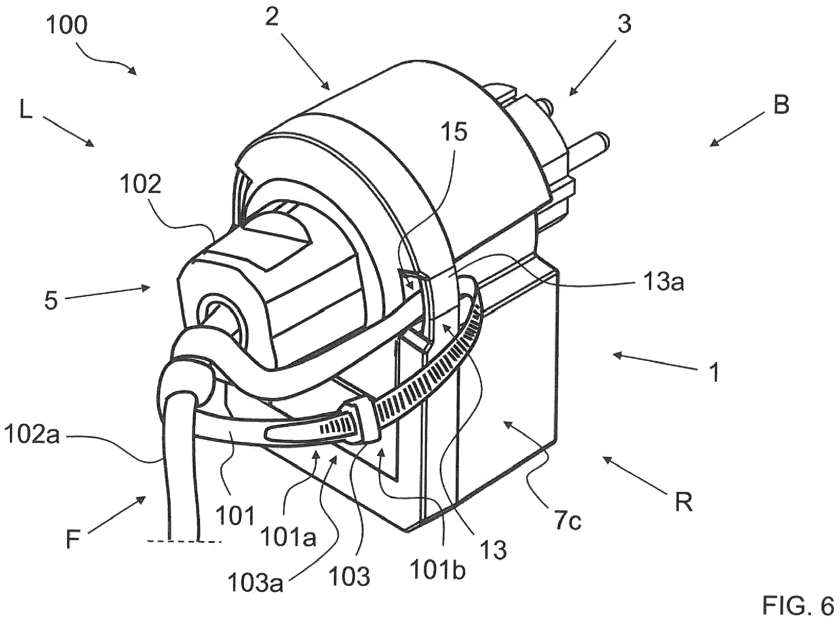

Erfindungsgemäß weist das Gehäuse 2 des Zwischensteckers 1 zwei Anbindevorrichtungen 13, 14 auf. Die beiden Anbindevorrichtungen 13, 14 sind dafür vorgesehen, einen hier nicht näher gezeigten und in die Gehäuse-Buchse 5 eingesteckten Netzstecker so an den Zwischenstecker 1 anzubinden, dass dieser nicht oder zumindest nicht ohne eine anschließende erkennbare Weise durch eine unberechtigte Person abziehbar ist. Hierzu sind die beiden Anbindevorrichtungen 13, 14 so ausgebildet, dass ein solcher Netzstecker unter Nutzung eines separaten und hier nicht näher gezeigten Anbindemittels 101 (siehe Fig. 6) an diese anbindbar ist.

Die beiden Anbindevorrichtungen 13, 14 sind jeweils im Bereich einer der beiden Nuten 9, 10 gelegen. Hierzu besitzt jede der beiden Anbindevorrichtungen 13, 14 einen Bügel 13a, 14a, der die zugehörige Nut 9, 10 unter Ausbildung je einer Durchgangsöffnung 15, 16 überbrückt. Bei näherer Betrachtung wird deutlich, dass die beiden Anbindevorrichtungen 13, 14 am Gehäuse-Deckel 8 des Gehäuses 2 im Bereich der Gehäuse-Buchse 5 angeordnet sind.

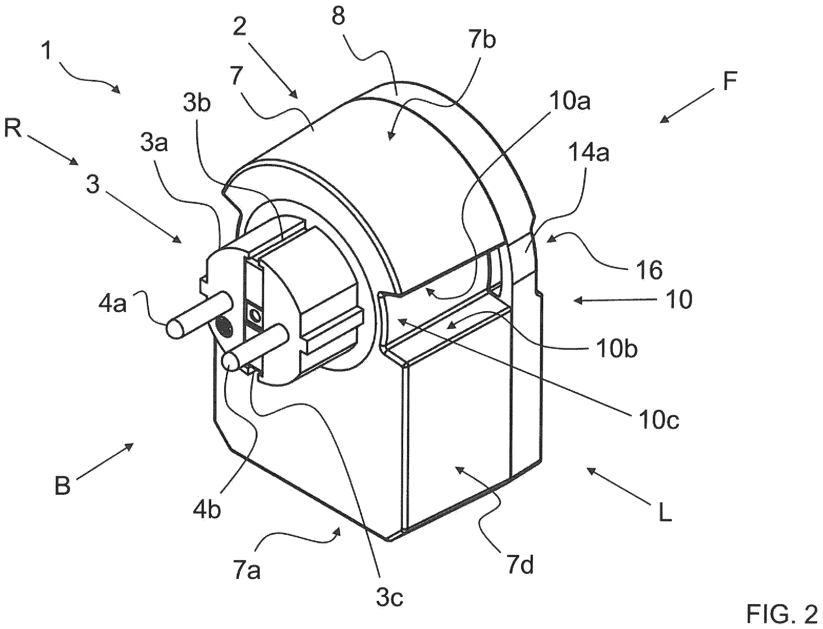

Fig. 2 zeigt den erfindungsgemäßen Zwischenstecker 1 in einer ebenfalls perspektivischen, gegenüber Fig. 1 allerdings um 180° gedrehten Darstellung. Hierdurch wird im Wesentlichen der Blick auf die Rückseite B des Zwischensteckers 1 ermöglicht. In dieser Ansicht wird deutlich, dass sich die jeweilige Nut 9, 10 von der Rückseite B des Gehäuses 2, insbesondere seines Gehäuse-Kastens 7, aus bis hin zum Gehäuse-Deckel 8 erstreckt, so dass deren jeweiligen Enden offen ausgestaltet sind.

Wie in der hier im Wesentlichen rückseitigen Ansicht gut erkennbar, ist der Gehäuse-Stecker 3 vorliegend als Schukostecker ausgebildet. Dies meint, dass der Gehäuse-Stecker 3 entsprechende Schutzkontakte 3b, 3c besitzt, die beim Einstecken des Gehäuse-Steckers 3 in eine hier nicht gezeigte Schukosteckdose über deren Erdungskontakte geerdet wird, bevor dessen Kontaktstifte 4a, 4b mit den stromführenden Buchsen der Schukosteckdose in Kontakt kommen.

Fig. 3 zeigt eine Ansicht des erfindungsgemäßen Zwischensteckers 1 auf dessen an der Vorderseite F gelegenen Gehäuse-Deckel 8. Zur besseren Übersicht wurde hierbei auf die Darstellung des Anzeigemittels 11 sowie des Bedienelements 12 und der Abdeckung 6 aus Fig. 1 verzichtet. Insbesondere durch die hier nicht gezeigte Abdeckung 6 ist der Blick auf die Gehäuse-Buchse 5 frei, welche erkennbar als Schukosteckdose ausgebildet ist. Die frontale Ansicht auf den Zwischenstecker 1 verdeutlicht, dass die Bügel 13a, 14a der beiden Anbindevorrichtungen 13, 14 jeweils gekrümmt ausgebildet sind. Jede der beiden Durchgangsöffnungen 15, 16 ist durch den zugehörigen Bügel 13a, 14a, eine dem jeweiligen Bügel 13a, 14a gegenüberliegende Teilfläche 15a, 16a des Gehäuse-Deckels 8 sowie jeweils zwei Öffnungsflanken 15b, 15c; 16b, 16c eingefasst und insofern begrenzt. Die Nutflanken 9a, 9b; 10a, 10b und die jeweils zugehörige Öffnungsflanke 15b, 15c; 16b, 16c erstrecken sich dabei in jeweils einer gemeinsamen Ebene, so dass diese quasi nahtlos ineinander übergehen. Selbiges gilt für den Nutgrund 9c, 10c der jeweiligen Nut 9, 10 und die zugehörige Teilfläche 15a, 16a des Gehäuse-Deckels 8, die sich ebenfalls auf jeweils einer gemeinsamen Ebene erstrecken und damit quasi nahtlos ineinander übergehen.

Erkennbar sind der jeweilige Nutgrund 9c, 10c und die zugehörige Teilfläche 15a, 16a des Gehäuse-Deckels 8 parallel zueinander gekrümmt ausgebildet. Insgesamt entspricht die Querschnittsform der jeweiligen Nut 9, 10 zumindest bereichsweise der Querschnittsform der zugehörigen Durchgangsöffnung 15, 16 der Anbindevorrichtung 13, 14. Weiterhin ersichtlich ist der untere Wandabschnitt 7a über jeweils eine Schrägfläche 17, 18 mit den seitlichen Wandabschnitten 7c, 7d verbunden. Hierdurch schließen die beiden seitliche Wandabschnitt 7c, 7d und die zugehörige Schrägfläche 17, 18 jeweils einen Winkel W1 von 135° zwischen sich ein. Auch der untere Wandabschnitt 7a schließt zwischen sich und jeder der beiden Schrägfläche 17, 18 jeweils einen Winkel W2 von 135° ein.

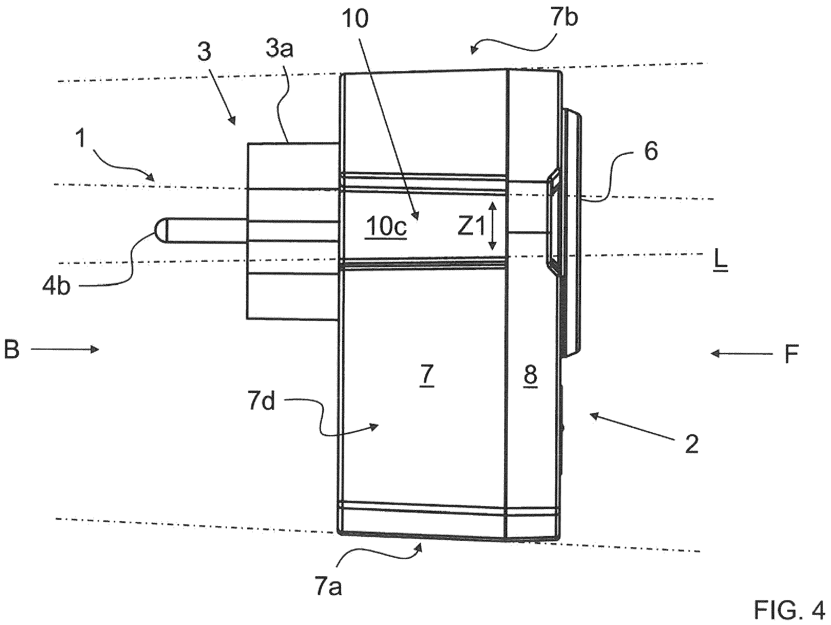

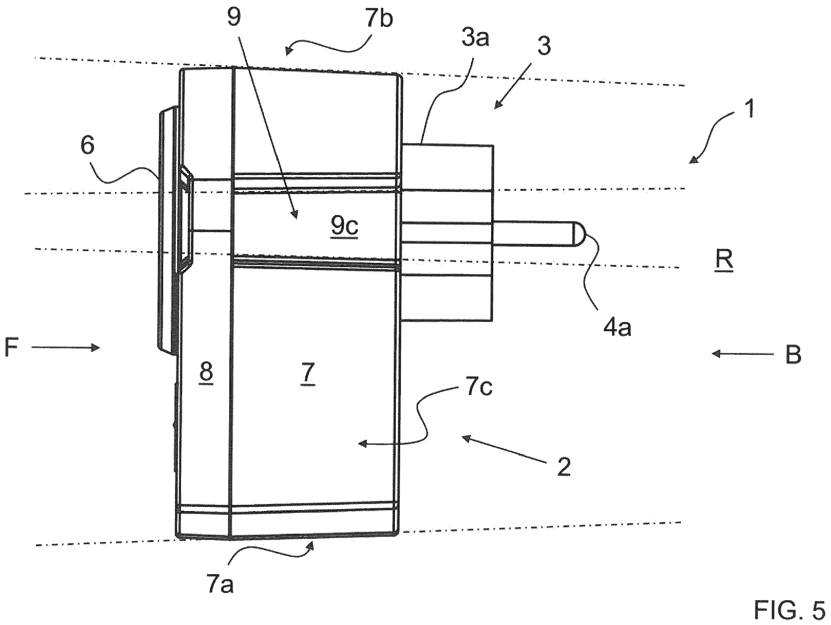

Die Fig. 4 und Fig. 5 zeigen den Zwischenstecker 1 jeweils in einer Ansicht auf seine beiden Gehäuseseiten L, R. Die beiden Darstellungen verdeutlichen, dass sich das Gehäuse 2 von seiner Vorderseite F ausgehend zur Rückseite B hin verjüngt. Besagte Verjüngung ist dabei auf die Form seines Gehäuse-Kastens 7 reduziert, der sich entsprechend vom Gehäuse-Deckel 8 ausgehend zur Rückseite B hin verjüngt. Mit Blick auf die jeweilige Nut 9, 10 ist ersichtlich, dass auch diese allerdings richtungsverkehrt zum Gehäuse 2 verjüngen. Dies meint, dass jede Nut 9, 10 sich ausgehend von der Rückseite B zur Vorderseite F hin verjüngt. Eine im Bereich des Gehäuse-Deckels 8 gelegene Breite Z1 des jeweiligen Nutgrunds 9c, 10c entspricht dabei einer im Bereich des Gehäuse-Kastens 7 gelegenen Breite Z2 der hier durch den jeweiligen Bügel 13a, 14a verdeckten Teilfläche 15a, 16a des Gehäuse-Deckels 8 (siehe Fig. 3). Insgesamt setzt sich somit der Verlauf der jeweiligen Nut 9, 10 zumindest bereichsweise im Verlauf der zugehörigen Durchgangsöffnung 13, 14 fort.

Fig. 6 ist ein erfindungsgemäßes mobiles Strommengen-Messsystem 100 zu entnehmen, welches einen wie aus den Fig. 1 bis 5 hervorgehenden Zwischenstecker 1 und ein Anbindemittel 101 umfasst. Bei dem Anbindemittel 101 handelt es sich vorliegend erkennbar um einen Kabelbinder. Weiterhin ist ein Netzstecker 102 dargestellt, welcher durch dessen einstecken in die Gehäuse-Buchse 5 des Zwischensteckers 1 so mit dieser gekoppelt ist, dass eine stromleitende Verbindung zwischen dem Gehäuse-Stecker 3 und dem Netzstecker 102 besteht. Erkennbar ist das strangförmig elastische Anbindemittel 101 um ein fest mit dem Netzstecker 102 verbundenes Anschlusskabel 102a gewickelt und mit einer Anbindevorrichtung 13 gekoppelt. Um das Anbindemittel 101 an die Anbindevorrichtung 13 anzubinden, ist dieses durch die Durchgangsöffnung 15 der Anbindevorrichtung 13 hindurch geführt, wobei es den Bügel 13a den Anbindevorrichtung 13 umgreift. Anschließend wurden die beiden Endabschnitte 101a, 101b des Anbindemittels 101 in für einen Kabelbinder typischer Weise dauerhaft miteinander verbunden, wodurch nunmehr ein erster Endabschnitt 101a des Anbindemittels 101 zumindest abschnittsweise durch eine Öffnung 103a eines am gegenüberliegenden zweiten Endabschnitt 101b angeordneten Rastkopf 103 des Anbindemittels 101 hindurchgeführt ist.

Im Ergebnis ist der Netzstecker 102 mitsamt seinem Anschlusskabel 102a quasi dauerhaft an die Anbindevorrichtung 13 des Zwischensteckers 1 angebunden, wobei der Netzstecker 102 nicht ohne eine Beschädigung oder gar Zerstörung des Anbindemittels 101 aus der Gehäuse-Buchse 5 des Zwischensteckers 1 herausziehbar ist. Dies liegt im Wesentlichen an der unveränderbaren Länge des Anbindemittels 101, die keinerlei Spiel für eine ausreichende Verlagerung des Netzsteckers 102 gegenüber dem Zwischensteckers 1 zulässt.

Selbstverständlich kann das vorliegend nur an die eine Anbindevorrichtung 13 angebundene Anbindemittel 101 auch an beide Anbindevorrichtungen 13,14 angebunden sein, um einen noch besseren Schutz gegenüber einem unberechtigten Abziehen des Netzsteckers 102 zu bieten.

### Bezugszeichenliste:

- 1: - Zwischenstecker
- 2: - Gehäuse von 1
- 3: - Gehäuse-Stecker von 1
- 4a: - Kontaktstift von 3
- 4b: - Kontaktstift von 3
- 5: - Gehäuse-Buchse von 1
- 6: - Abdeckung von 5
- 7: - Gehäuse-Kasten von 2
- 7a: - Wandabschnitt, unten
- 7b: - Wandabschnitt, oben
- 7c: - Wandabschnitt, seitlich
- 7d: - Wandabschnitt, seitlich
- 8: - Gehäuse-Deckel von 2
- 9: - Nut an 2
- 9a: - Nutflanke von 9
- 9b: - Nutflanke von 9
- 9c: - Nutgrund von 9
- 10: - Nut an 2
- 10a: - Nutflanke von 10
- 10b: - Nutflanke von 10
- 10c: - Nutgrund von 10
- 11: - Anzeigemittel von 1
- 12: - Bedienmittel von 1
- 13: - Anbindevorrichtung von 1
- 13a: - Bügel von 13
- 14: - Anbindevorrichtung von 1
- 14a: - Bügel von 14
- 15: - Durchgangsöffnung von 13
- 15a: - Teilfläche von 2
- 15b: - Öffnungsflanke von 15
- 15c: - Öffnungsflanke von 15
- 16: - Durchgangsöffnung von 14
- 16a: - Teilfläche von 2
- 16b: - Öffnungsflanke von 16
- 16c: - Öffnungsflanke von 16
- 17: - Schrägfläche zwischen 7a und 7d
- 18: - Schrägfläche zwischen 7a und 7c

- 100: - Strommengen-Messsystem, mobil
- 101: - Anbindemittel von 100
- 101a: - Endabschnitt, erster
- 101b: - Endabschnitt, zweiter
- 102: - Netzstecker
- 102a: - Anschlusskabel von 102
- 103: - Rastkopf von 101

- B: - Rückseite von 1
- F: - Vorderseite von 1
- L: - Gehäuseseite von 2
- R: - Gehäuseseite von 2
- W1: - Winkel zwischen 17 und 7d oder 18 und 7c
- W2: - Winkel zwischen 7a und 17 oder 18
- Z1: - Breite von 9c und 10c
- Z2: - Breite von 15a und 16a

## Patentansprüche

1. Zwischenstecker (1) zur stromführenden Eingliederung zwischen einer Steckdose und wenigstens einem elektrischen Verbraucher, umfassend ein Gehäuse (2) mit einem zur Kopplung mit der Steckdose ausgebildeten Gehäuse-Stecker (3), insbesondere Schukostecker, sowie wenigstens einer zur Kopplung mit einem Netzstecker (102) ausgebildeten Gehäuse-Buchse (5), insbesondere Schukosteckdose, wobei das Gehäuse (2) eine Messvorrichtung besitzt, durch welche eine über die Gehäuse-Buchse (5) weiterleitbare Menge an Strom erfassbar ist,
**dadurch gekennzeichnet, dass**
das Gehäuse (2) wenigstens eine Anbindevorrichtung (13, 14) aufweist, an die ein in die Gehäuse-Buchse (5) eingesteckter Netzstecker (102) zumindest indirekt, insbesondere über ein separates Anbindemittel (101), anbindbar ist.

2. Zwischenstecker (1) nach Anspruch 1,
**dadurch gekennzeichnet, dass**
die Anbindevorrichtung (13, 14) wenigstens eine Durchgangsöffnung (15, 16) aufweist.

3. Zwischenstecker (1) nach Anspruch 1 oder 2,
**dadurch gekennzeichnet, dass**
die Anbindevorrichtung (13, 14) wenigstens einen Bügel (13a, 14a) besitzt.

4. Zwischenstecker (1) nach Anspruch 3,
**dadurch gekennzeichnet, dass**
die Durchgangsöffnung (15, 16) der Anbindevorrichtung (13, 14) zumindest teilweise durch den Bügel (13a, 14a) begrenzt ist.

5. Zwischenstecker (1) nach einem der Ansprüche 1 bis 4,
**dadurch gekennzeichnet, dass**
das Gehäuse (2) wenigstens eine Nut (9, 10) aufweist, wobei die Anbindevorrichtung (13, 14) zumindest teilweise im Bereich der Nut (9, 10) angeordnet ist.

6. Zwischenstecker (1) nach Anspruch 5,
**dadurch gekennzeichnet, dass**
das Gehäuse (2) zwei sich gegenüberliegende Gehäuseseiten (L, R) besitzt, wobei an einer oder an jeder dieser Gehäuseseiten (L, R) eine Nut (9, 10) angeordnet ist.

7. Zwischenstecker (1) nach Anspruch 5 oder 6,
**dadurch gekennzeichnet, dass**
die Nut (9, 10) unter Ausbildung der Durchgangsöffnung (15, 16) zumindest teilweise durch den Bügel (13a, 14a) der Anbindevorrichtung (13, 14) überbrückt ist.

8. Zwischenstecker (1) nach einem der Ansprüche 1 bis 7,
**dadurch gekennzeichnet, dass**
das Gehäuse (2) einen den Gehäuse-Stecker (3) aufweisenden Gehäuse-Kasten (7) und einen die Gehäuse-Buchse (5) aufweisenden Gehäuse-Deckel (8) umfasst, wobei die wenigstens eine Anbindevorrichtung (13, 14) am Gehäuse-Deckel (8) im Bereich der Gehäuse-Buchse (5) angeordnet ist.

9. Zwischenstecker (1) nach Anspruch 8,
**dadurch gekennzeichnet, dass**
sich wenigstens eine Nut (9, 10) von einer Rückseite (B) des Gehäuses (2), insbesondere des Gehäuse-Kastens (7), aus bis hin zum Gehäuse-Deckel (8) erstreckt, wobei ein Nutgrund (9c, 10c) der Nut (9, 10) sowie eine dem Bügel (13a, 14a) der Anbindevorrichtung (13, 14) gegenüberliegende und die Durchgangsöffnung (15, 16) zumindest bereichsweise begrenzende Teilfläche (15a, 16ab) des Gehäuse-Deckels (8) sich auf einer gemeinsamen Ebene erstrecken.

10. Zwischenstecker (1) nach einem der Ansprüche 5 bis 9,
**dadurch gekennzeichnet, dass**
die Querschnittsform der Nut (9, 10) zumindest bereichsweise der Querschnittsform der Durchgangsöffnung (15, 16) der Anbindevorrichtung (13, 14) entspricht.

11. Zwischenstecker (1) nach einem der Ansprüche 1 bis 10,
**dadurch gekennzeichnet, dass**
das Gehäuse (2) ein, insbesondere mit der als MID-Energiezähler ausgebildeten Messvorrichtung verbundenes, Anzeigemittel (11) zur zumindest bedarfsweisen Darstellung eines Werts für die jeweils erfasste Menge an Strom besitzt.

12. Zwischenstecker (1) nach einem der Ansprüche 1 bis 11,
**dadurch gekennzeichnet, dass**
das Gehäuse (2) mindestens ein, insbesondere mit der als MID- Energiezähler ausgebildeten Messvorrichtung verbundenes, Bedienelement (12) zur Ansteuerung, insbesondere eines Anzeigemittels (11), der Messvorrichtung besitzt.

13. Zwischenstecker (1) nach einem der Ansprüche 1 bis 12,
**dadurch gekennzeichnet, dass**
der Gehäuse-Stecker (3) und die Gehäuse-Buchse (5) miteinander fluchtend in und/oder an dem Gehäuse (2) angeordnet sind.

14. Mobiles Strommengen-Messsystem (100), umfassend einen Zwischenstecker (1) nach einem der vorhergehenden Ansprüche 1 bis 13 und wenigstens ein Anbindemittel (101), wobei das Anbindemittel (101) dazu ausgebildet ist, einen mit einer Gehäuse-Buchse (5) des Zwischensteckers (1) gekoppelten Netzstecker (102) an eine Anbindevorrichtung (13, 14) des Zwischensteckers (1), insbesondere ausziehsicher, anzubinden.

15. Strommengen-Messsystem (100) nach Anspruch 14,
**dadurch gekennzeichnet, dass**
das Anbindemittel (101) gemäß wenigstens einer der nachfolgend genannten, insbesondere strangförmigen und nur durch deren Zerstörung lösbaren, Ausführungsformen ausgebildet ist oder wenigstens eine dieser Ausführungsformen enthält:
- Kabelbinder,
- Drahtplombe,
- Fadenplombe,
- Bandplombe,
- Plombierdraht,
- Plombierfaden,
- Plombierband.
